(19) Europäisches Patentamt

European Patent Office

Office européen des brevets

(11) EP 0 905 852 A1

(12) DEMANDE DE BREVET EUROPEEN

(43) Date de publication:
31.03.1999 Bulletin 1999/13

(51) Int Cl.⁶: **H02H 9/04**

(21) Numéro de dépôt: 98410109.7

(22) Date de dépôt: 29.09.1998

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **29.09.1997 FR 9712297**

(71) Demandeur: **STMicroelectronics SA**
**94250 Gentilly Cedex (FR)**

(72) Inventeur: **Berthiot, Denis**
**37000 Tours (FR)**

(74) Mandataire: **de Beaumont, Michel**
**1bis, rue Champollion**
**38000 Grenoble (FR)**

(54) **Circuit de protection associable à un filtre**

(57)     L'invention concerne une structure de protection contre des surcharges électriques connectée entre deux bornes d'entrée (11, 12) et deux bornes de sortie (13, 14). Les bornes de sortie sont reliées aux entrées d'un circuit (3) à protéger. Une première borne d'entrée (11) est reliée à une première borne de sortie (13) par l'intermédiaire d'une impédance (Z). La deuxième borne d'entrée (12) est reliée à la deuxième borne de sortie (14). Les bornes d'entrée (11, 12) sont reliées par une première diode à avalanche (Z1). Les bornes de sortie (13, 14) sont reliées par une deuxième diode à avalanche (Z2) de même polarité que la première diode à avalanche.

Fig 2

**Description**

La présente invention concerne le domaine des circuits de protection contre des surcharges de composants et/ou équipements électroniques tels que par exemple des téléphones portables, des ordinateurs, des imprimantes. On cherche tout particulièrement à protéger de tels équipements contre des surcharges électrostatiques qui peuvent par exemple correspondre à des pics de courant brefs mais de très fortes intensités, par exemple plusieurs dizaines d'ampères.

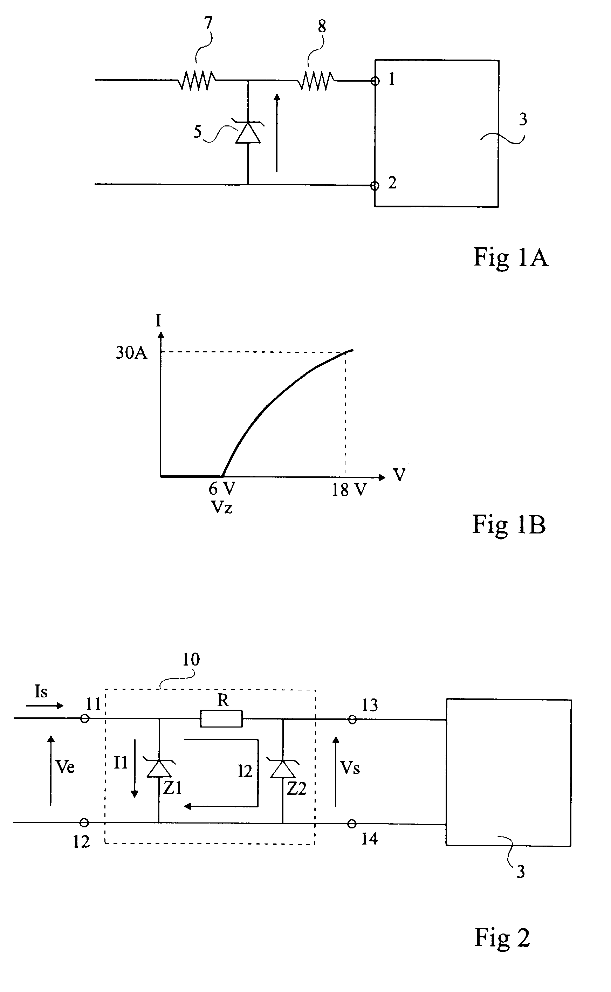

De façon classique, comme le représente la figure 1A, pour protéger des entrées 1 et 2 d'un équipement 3 connecté à des éléments externes, on dispose entre ces entrées une diode à avalanche 5 ou un dispositif équivalent. Des résistances 7 et 8 correspondant à des résistances de connexion ou à des résistances volontairement insérées dans le circuit.

Théoriquement, comme le représente la figure 1B, une diode à avalanche impose à ses bornes une tension $V_Z$. Toutefois, quand le courant dans cette diode croît de façon importante, comme le représente 1B, la tension V aux bornes de la diode à avalanche croît pour atteindre une valeur $V_s$ égale $V_Z = R_Z I$, où I est le courant lié à la surcharge. Pour prendre un exemple pratique, si l'on considère une diode à avalanche d'une surface d'environ 0,4 mm$^2$, dans les technologies classiques, la résistance dynamique équivalente $R_Z$ sera de l'ordre de 0,4 ohm. Si le pic de surcharge de courant est de l'ordre de 30 ampères, la tension réelle aux bornes d'une diode à avalanche ayant une tension de claquage de 6 volts sera de 6 + 0,4 x 30 = 18 volts. La valeur réelle est le triple de la tension nominale et il peut en résulter une destruction des composants du circuit à protéger.

Il est connu que pour réduire la résistance dynamique d'une diode à avalanche, il convient d'augmenter sa surface. Si l'on augmente la surface d'un facteur 4, pour atteindre par exemple une surface de 1,6 mm$^2$, on aura une résistance équivalente de seulement 0,1 ohm. La surtension liée au passage du courant sera seulement de 3 volts, c'est-à-dire que la tension aux bornes de la diode à avalanche atteindra pour 30 ampères une valeur de l'ordre de 9 volts, ce qui reste acceptable.

Toutefois, ceci présente l'inconvénient que le coût d'une diode augmente avec sa surface et qu'il faut prévoir une surface importante pour que l'augmentation de la tension avec le courant devienne négligeable.

De plus, une diode à avalanche présente inévitablement à l'état bloqué une certaine capacité parasite. Dans un cas classique, pour une diode de 0,4 mm$^2$, on aura une capacité parasite de l'ordre de 250 pF. Si on multiplie la surface de la diode par 4, la capacité parasite quadruplera pour atteindre une valeur de l'ordre du nanofarad. Il en résulte que le système de protection présente une capacité élevée qui ne peut être choisie indépendamment du choix de la résistance. Ceci peut constituer un inconvénient dans certaines applications.

Ainsi, un objet de la présente invention est de remédier aux inconvénients des systèmes de l'art antérieur tels que décrits ci-dessus.

Un objet plus particulier de la présente invention est de prévoir une structure de protection telle que la tension à ses bornes reste proche de la valeur nominale prévue.

Un autre objet de la présente invention est de prévoir une telle structure qui occupe une surface de silicium réduite.

Un autre objet de la présente invention est de prévoir une telle structure qui présente une caractéristique de filtrage choisie.

Pour atteindre ces objets, la présente invention prévoit une structure de protection contre des surcharges électriques, connectée entre deux bornes d'entrée et deux bornes de sortie, les bornes de sortie étant reliées aux entrées d'un circuit à protéger, une première borne d'entrée étant reliée à une première borne de sortie par l'intermédiaire d'une impédance, la deuxième borne d'entrée étant reliée à la deuxième borne de sortie, les bornes d'entrée étant reliées par une première diode à avalanche, les bornes de sortie étant reliées par une deuxième diode à avalanche de même polarité que la première diode à avalanche.

Selon un mode de réalisation de la présente invention, les deux diodes à avalanche sont identiques.

Selon un mode de réalisation de la présente invention, les deux diodes à avalanche sont bidirectionnelles.

Selon un mode de réalisation de la présente invention, l'impédance est une résistance connectée entre les premières bornes d'entrée et de sortie.

Selon un mode de réalisation de la présente invention, l'impédance est une impédance tripôle dont une troisième borne est reliée aux deuxièmes bornes d'entrée et de sortie, les éléments du tripôle constituant, avec les diodes à avalanche une structure de filtrage.

Selon un mode de réalisation de la présente invention, le tripôle comprend deux résistances série et un condensateur parallèle.

La présente invention prévoit aussi une réalisation monolithique de la structure ci-dessus comprenant, dans un substrat du premier type de conductivité, deux zones du deuxième type de conductivité formant avec le substrat des jonctions Zener, et une métallisation formée sur la surface supérieure du substrat avec interposition d'une couche isolante.

EP 0 905 852 A1

Selon un avantage de la présente invention qui sera exposée plus en détail ci-après, la structure selon la présente invention se prête tout particulièrement à être combinée avec des structures assurant des effets de filtrage déterminées.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1A représente une structure de protection selon l'art antérieur ;
la figure 1B représente la caractéristique électrique courant-tension de la structure de protection de la figure 1A ;
la figure 2 représente un exemple de réalisation d'une structure de protection selon la présente invention ;
la figure 3 représente une forme générale de la structure de protection selon la présente invention ;
les figures 4A, 4B, 4C représentent diverses variantes de la structure de protection selon la présente invention ; et
la figure 5 représente un exemple de réalisation sous forme d'une structure monolithique de la structure de protection de la figure 4C.

Comme le représente la figure 2, une structure de protection 10 selon la présente invention comprend des bornes d'entrée 11 et 12 et des bornes de sortie 13 et 14 connectées au circuit 3 à protéger. Les bornes 12 et 14 sont interconnectées. Les bornes 11 et 13 sont reliées par l'intermédiaire d'une résistance R. Les bornes 11 et 12 sont reliées par l'intermédiaire d'une diode à avalanche Z1. Les bornes 13 et 14 sont reliées par l'intermédiaire d'une diode à avalanche Z2.

Si l'on suppose que les diodes à avalanche Z1 et Z2 sont identiques et ont la même tension d'avalanche $V_Z$ et la même résistance dynamique $R_Z$, on peut écrire que le courant d'entrée $I_s$ dû à une surcharge est :

$$I_s = I_1 + I_2 \tag{1}$$

où I1 désigne le courant dans la diode à avalanche Z1 et $I_2$ le courant dans la diode à avalanche Z2.

En négligeant le courant sortant par la borne 13, on peut écrire :

$$I_1 R_Z = I_Z (R + R_Z). \tag{2}$$

On en déduit :

$$I_s = I_1\left(1 + \frac{R_Z}{R + R_Z}\right) = I_1\left(\frac{R + 2R_Z}{R + R_Z}\right) \tag{3}$$

$$I_s = I_2\left(1 + \frac{R + R_Z}{R_Z}\right) = I_2\left(\frac{R + 2R_Z}{R_Z}\right) \tag{4}$$

Ainsi, la tension d'entrée Ve due à une surcharge peut s'écrire :

$$V_e = V_Z + R_Z I_s \frac{R + R_Z}{R + 2R_Z} \tag{5}$$

et la tension de sortie est alors :

$$V_s = V_Z + R_Z I_s\left(\frac{R_Z}{R + 2R_Z}\right) \tag{6}$$

L'équation (6) montre bien que si la valeur R est nettement supérieure à la valeur $R_Z$, la tension de sortie $V_s$ est sensiblement égale à $V_Z$.

Dans un exemple particulier où la résistance $R_Z$ est comme précédemment égale à 0,4 ohm et où R = 50

3

ohms, le facteur RZ/(R+2RZ) est égal à 0,4/50,8 soit environ 1/100.

Ainsi, en utilisant pour les diodes Z1 et Z2 la même diode que la diode 5 de la figure 1A, on a une surtension de seulement environ 0,1 volt due au passage du courant au lieu d'une surtension de 12 volts. Ceci montre que, tout en gardant une surtension très raisonnable, on peut diminuer encore la surface des diodes à avalanche pour réduire encore la capacité parasite des diodes en parallèle. On pourra par exemple utiliser des diodes quatre fois plus petites ayant chacune une capacité parasite de l'ordre de 70 pF.

L'homme de l'art notera que la structure de la figure 2 est susceptible de diverses variantes, les deux diodes Z1 et Z2 n'étant pas nécessairement identiques mais pouvant être adaptées à des cas particuliers.

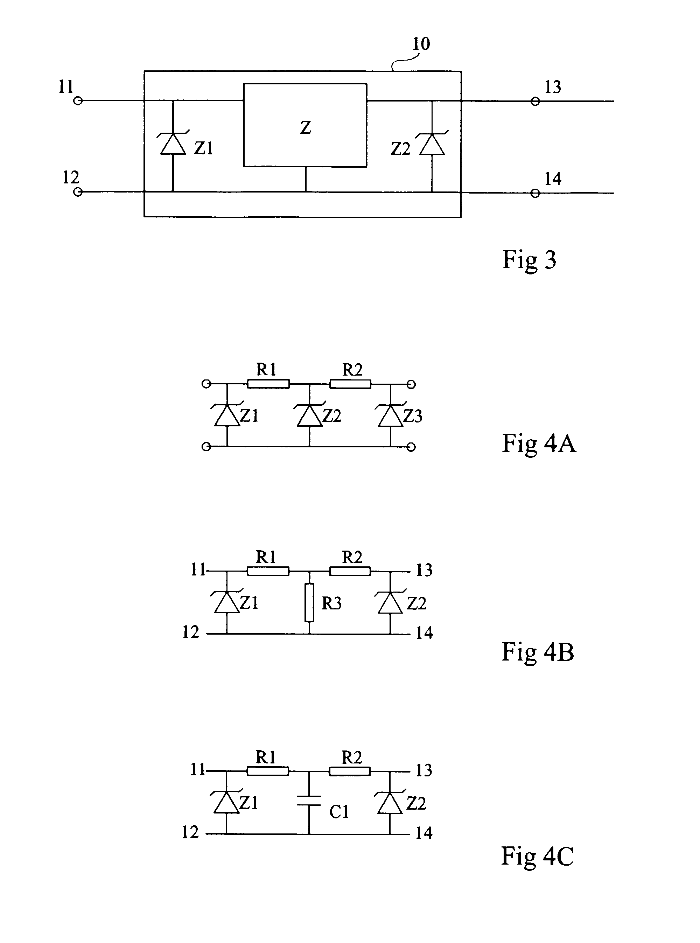

Plus généralement, le circuit de protection 10 selon la présente invention peut être tel que représenté en figure 3, la résistance R étant remplacée par une impédance tripôle Z. Les calculs exposés précédemment s'appliquent en considérant que la valeur R est la résistance série du tripôle Z.

Différents exemples particuliers du schéma général de la figure 3 sont représentés à titre d'exemple en figures 4A à 4C.

En figure 4A, on a utilisé un ensemble d'une résistance R2 et d'une diode à avalanche Z3 en plus des diodes à avalanche Z1 et Z2 et de la résistance R (désignée par R1 en figure 4A). Ainsi, si le premier ensemble permet de gagner un facteur 100 sur la surtension apportée par la surcharge en courant, l'ensemble complémentaire R2-Z3 permettra d'obtenir un facteur d'amélioration 100 supplémentaire, c'est-à-dire une variation de tension seulement de l'ordre de 1/10000. Ce montage pourra être utilisé dans des cas où la disposition en série de deux résistances R1 et R2 ne nuit pas au fonctionnement du circuit et permet, par le choix notamment de la capacité de la diode Z2 d'assurer une fonction de filtre passe-bas.

La figure 4B représente une structure dans laquelle le tripôle Z comprend deux résistances R1 et R2 en série entre les bornes 11 et 13 et une résistance R3 entre le point de raccordement des résistances R1 et R2 et les bornes 12, 14. Un avantage de cette structure est d'insérer un pont diviseur supplémentaire de la surtension.

Dans le cas de la figure 4C, l'impédance Z est un tripôle comprenant deux résistances R1 et R2 en série entre les bornes 11 et 13 et un condensateur C1 entre le point de raccordement des résistances R1 et R2 et les bornes 12, 14.

Comme le notera l'homme de l'art, cet ensemble constitue un filtre de type passe-bas et permet par exemple de supprimer la porteuse dans un téléphone portable. Ce filtre a des fréquences de coupure $f_1=1/RC_1\omega$ et $f_Z=1/RC_Z\omega$, où $C_Z$ désigne la capacité d'une diode à avalanche, une première atténuation apparaissant pour la première fréquence de coupure et une atténuation plus forte apparaissant pour la deuxième fréquence de coupure.

Pour R1 = R2 = R = 250 $\Omega$, C1 = 25 pF, et $C_Z$ = 70 pF, on obtient $f_Z$ = 45 MHz et $f_1$ = 64 MHz.

Pour R1 = R2 = R = 50 $\Omega$, C1 = 50 pF, et $C_Z$ = 70 pF, on obtient $f_Z$ = 9 MHz et $f_1$ = 25 MHz.

Ainsi, la présente invention permet de combiner de façon simple une structure de protection et une structure de filtrage.

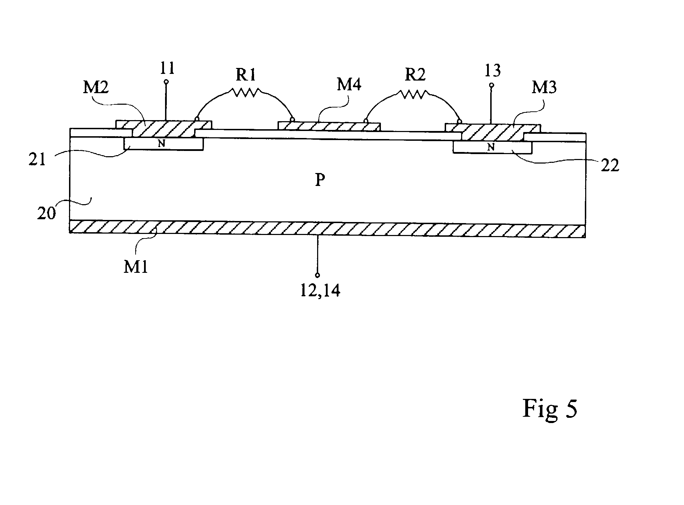

La figure 5 représente un mode de réalisation monolithique de la structure de la figure 4C. Dans l'exemple représenté, la structure est formée dans un substrat 20 de type P dans lequel sont formées deux régions de type N 21 et 22 formant avec le substrat des jonctions Zener. La face inférieure du composant est revêtue d'une métallisation M1 correspondant aux bornes 12 et 14 de la figure 4C. Des métallisations M2 et M3 formées sur les régions 21 et 22 correspondent aux bornes 11 et 13. Un condensateur peut être réalisé entre une métallisation M4 et le substrat 1 et correspond au condensateur C1 de la figure 4C. Les résistances R1 et R2 pourront être formées de toute façon connue, par exemple en prévoyant des conducteurs minces constituant une partie de la métallisation dont sont formés les contacts M2, M3 et M4. On pourra aussi prévoir des résistances dans une couche de silicium polycristallin ou encore des résistances diffusées formées dans des caissons eux-mêmes formés dans le substrat 20.

Comme on l'a indiqué précédemment, la surface totale des jonctions 21 et 22 peut être très faible.

Bien entendu, diverses variantes de réalisation de la structure de la figure 5 et des circuits illustrés à titre d'exemple en figures 4A à 4C pourront être imaginées par l'homme de l'art sans sortir du domaine de l'invention. De plus, bien que la présente invention ait été décrite avec un composant de protection unidirectionnel, elle s'applique bien entendu aussi à des composants de protection bidirectionnels.

## Revendications

1.   Structure de protection contre des surcharges électriques, connectée entre deux bornes d'entrée (11, 12) et deux bornes de sortie (13, 14), les bornes de sortie étant reliées aux entrées d'un circuit (3) à protéger, une première borne d'entrée (11) étant reliée à une première borne de sortie (13) par l'intermédiaire d'une impédance (Z), caractérisé en ce que :

la deuxième borne d'entrée (12) est reliée à la deuxième borne de sortie (14) ;

les bornes d'entrée (11, 12) sont reliées par une première diode à avalanche (Z1) ;

les bornes de sortie (13, 14) sont reliées par une deuxième diode à avalanche (Z2) de même polarité que la première diode à avalanche.

2. Structure selon la revendication 1, caractérisée en ce que les deux diodes à avalanche sont identiques.

3. Structure selon la revendication 1, caractérisée en ce que les deux diodes à avalanche sont bidirectionnelles.

4. Structure selon la revendication 1, caractérisée en ce que l'impédance (Z) est une résistance (R) connectée entre les premières bornes d'entrée et de sortie (11, 13).

5. Structure selon la revendication 1, caractérisée en ce que l'impédance (Z) est une impédance tripôle dont une troisième borne est reliée aux deuxièmes bornes d'entrée (12) et de sortie (14), les éléments du tripôle constituant, avec les diodes à avalanche une structure de filtrage.

6. Structure selon la revendication 5, caractérisée en ce que le tripôle comprend deux résistances série (R1, R2) et un condensateur parallèle (C1).

7. Réalisation monolithique d'une structure selon la revendication 6, comprenant, dans un substrat (20) du premier type de conductivité, deux zones (21, 22) du deuxième type de conductivité formant avec le substrat des jonctions Zener, et une métallisation (M4) formée sur la surface supérieure du substrat avec interposition d'une couche isolante.

Fig 1A

Fig 1B

Fig 2

Fig 3

Fig 4A

Fig 4B

Fig 4C

Fig 5

EP 0 905 852 A1

| | Office européen des brevets | RAPPORT DE RECHERCHE EUROPEENNE | Numéro de la demande<br>EP 98 41 0109 |

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (Int.Cl.6) |
|---|---|---|---|
| A | EP 0 569 221 A (XEROX CORP)<br>10 novembre 1993<br>* abrégé * | 1 | H02H9/04 |
| A | GB 2 172 453 A (DUBILIER BESWICK DIV)<br>17 septembre 1986<br>* abrégé * | 1 | |

| | DOMAINES TECHNIQUES<br>RECHERCHES (Int.Cl.6) |
|---|---|
| | H02H<br>H01L |

Le présent rapport a été établi pour toutes les revendications

| Lieu de la recherche | Date d'achèvement de la recherche | Examinateur |
|---|---|---|
| LA HAYE | 6 janvier 1999 | Salm, R |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**   EP 98 41 0109

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-01-1999

| Document brevet cité au rapport de recherche | Date de publication | Membre(s) de la famille de brevet(s) | Date de publication |
|---|---|---|---|
| EP 0569221 A | 10-11-1993 | JP 6021346 A | 28-01-1994 |
| GB 2172453 A | 17-09-1986 | AUCUN | |

EPO FORM P0460